# EUROPÄISCHE PATENTSCHRIFT

(11) **EP 0 321 589 B1**
(45) Veröffentlichungstag und Bekanntmachung des Hinweises auf die Patenterteilung: **24.03.1993**
(21) Anmeldenummer: 87114545.4
(22) Anmeldetag: 06.10.1987
(51) Int. Cl.: G06F 5/06, G11C 19/00

(54) **Digitaler FIFO-Speicher**
Digital FIFO memory
Mémoire FIFO numérique

(43) Veröffentlichungstag der Anmeldung: 28.06.1989
(73) Patentinhaber: Deutsche ITT Industries GmbH, 79108 Freiburg (DE)
(72) Erfinder: Theus, Ulrich, Dr. Ing., D-7803 Gundelfingen (DE)

(56) Entgegenhaltungen:
- US-A- 3 708 690
- US-A- 3 745 535
- NUCLEAR INSTRUMENTS AND METHODS, Band 65, Nr. 2, 1. November 1968, Seiten 202-204, North-Holland Publishing Co.; G. PHILOKYPROU et al.: "The stacking register - A simultaneous input/output buffer"

## Beschreibung

Die Erfindung betrifft einen digitalen FIFO-Speicher mit einem Speicherzellenfeld von n signalflußmäßig parallelen Signalzweigen, deren Eingänge mit dem Dateneingang des Speichers und deren Ausgänge mit dessen Datenausgang gekoppelt sind, wobei jeder Signalzweig m signalflußmäßig in Reihe liegende, untereinander gleiche Speicherzellen mit je einem Enable-Eingang enthält und diese mit Taktsignalen derart gespeist sind, daß in Signalflußrichtung benachbarte Speicherzellen nacheinander leitend gesteuert werden, vgl. den ausführlichen Wortlaut des ersten Teils von Anspruch 1. Ein derartiger FIFO-Speicher ist in US-A 3,745,535 beschrieben. ("FIFO" ist die Abkürzung von First-In-First-Out).

Bei der bekannten Anordnung bestehen die einzelnen Speicherzellen aus J/K-Flip-Flop-Stufen, deren Steuerung über gleichartig aufgebaute Takttreiber erfolgt, die jeweils ebenfalls aus einer J/K-Flip-Flop-Stufe bestehen. Diese sind mit einem Grundtaktsignal gespeist, dessen Frequenz größer als das doppelte der maximalen Eingangsdatenrate ist. Die Takttreiber sind dabei so mit den jeweiligen Nachbar-Takttreibern verkoppelt, daß beim Anliegen gültiger Eingangsdaten diese nacheinander so durch die hintereinandergeschalteten Speicherzellen geschoben werden, daß sie am Ausgang abgreifbar sind.

In US-A 3,708,690 ist ein Mehrphasenschieberegister in MOS- oder CMOS-Technik beschrieben, dessen Speicherzellen aus einem Pegelregenerierer mit nachgeschaltetem Transfertransistor bestehen. Der Pegelregenerierer besteht aus zwei mit ihrem gesteuerten Strompfad parallel zwischen dem Takteingang und dem gesteuerten Strompfad des Transfertransistors liegenden Transistoren, dessen anderes Strompfadende zum Gate des einen Pegelregenerier-Transistors der nächsten Speicherzelle führt und über einen Kondensator mit dem Bezugspunkt für das Taktsignal verbunden ist, während das Gate des anderen Pegelregenerier-Transistors am Takteingang liegt und das Gate des Transfertransistors der Enable-Eingang ist.

Dieses Mehrphasenschieberegister aus US-A 3,708,690, aber auch ein FIFO-Speicher aus einer nicht vorveröffentlichten eigenen EP-A 243 528 werden ausschließlich mit Taktsignalen betrieben, die von einem einzigen Grundtaktsignal abgeleitet sind.

Aus der genannten US-A 3,708,690 sind für die Schieberegisteranordnung ferner Einrichtungen zur Parallelisierung des zugeführten seriellen Datenstroms und zu dessen Rückwandlung bekannt, wobei am Eingang der Datenstrom mittels eines Demultiplexers parallelisiert und am Ausgang mittels eines Multiplexers wieder in Serienform gebracht wird. Die einzelnen Speicherzellen sind dabei in einem rechteckförmigen Feld angeordnet, wobei die Anzahl der Zeilen und die Anzahl der Spalten zwangsweise in einem einfachen, ganzzahligen Verhältnis stehen. Die Anzahl der Spalten ist dabei durch die Datenwortlänge bestimmt. Die einzelnen zu jeweils einem Schieberegister zusammengeschalteten Speicherzellen enthalten Speicherkondensatoren, die über geschaltete MOS-Transistoren umgeladen werden, wobei die Isolierung der Speicherkondensatoren über MOS-Transfertransistoren erfolgt.

Der in den Ansprüchen gekennzeichneten Erfindung liegt die Aufgabe zugrunde, einen digitalen FIFO-Speicher für einen seriellen Datenstrom so weiterzubilden, daß er mit einem kleinen Bedarf an Kristallfläche monolithisch mit Isolierschicht-Feldeffekttransistoren integriert werden kann.

Die Erfindung wird nun anhand der Figuren der Zeichnung näher erläutert:
Fig. 1 zeigt in stark schematisierter Darstellung als Ausführungsbeispiel der Erfindung das Schaltbild des Zellenfelds zusammen mit drei verschiedenen Schaltungsvarianten einer Speicherzelle.
Fig. 2 zeigt in Weiterbildung der Fig. 1 deren Zellenfeld zusammen mit einem eingangsseitigen Demultiplexer,
Fig. 3 zeigt in Weiterbildung der Fig. 1 deren Zellenfeld zusammen mit einem eingangsseitigen Demultimplexer und einem ausgansseitigen Multiplexer für Speicherzellen nach Fig. 1c,
Fig. 4 zeigt ein der Fig. 3 entsprechendes Zellenfeld, jedoch für Speicherzellen nach Fig. 1d oder Fig. 1e,
Fig. 5 zeigt das Schaltbild eines Ausführungsbeispiels eines Takttreibers mit N-Transistoren,
Fig. 6 zeigt das Schaltbild eines Ausführungsbeispiels für den die Taktsignale des ausgangsseitigen Multiplexers erzeugenden Ringzähler,
Fig. 7 zeigt das Schaltbild eines Ausführungsbeispiels für den die Taktsignale des eingangsseitigen Demultiplexers erzeugenden Ringzähler,

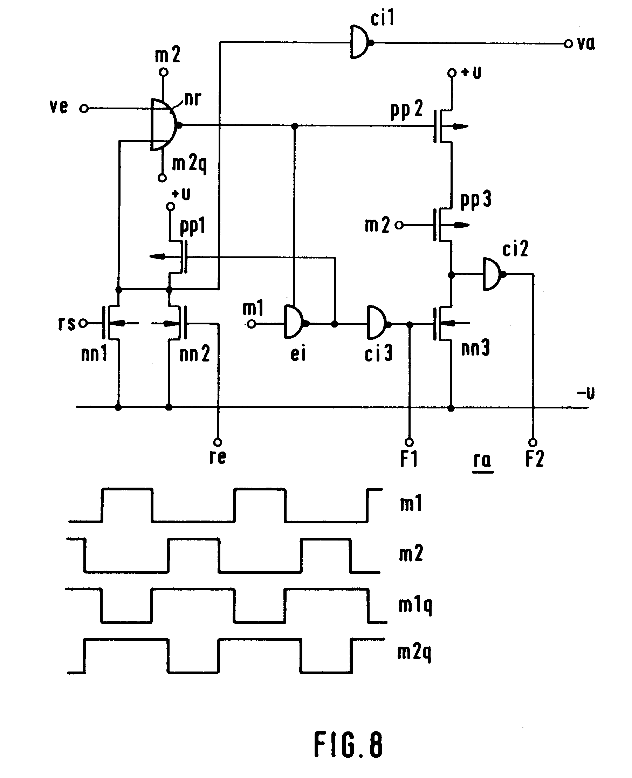

Fig. 8 zeigt das Schaltbild eines Ausführungsbeispiels eines CMOS-Takttreibers, und
Fig. 9 zeigt eine Schar von Signalverläufen, die bei einer Anordnung nach den Fig. 3 und 5 bis 7 auftreten, wenn m = n = 4 ist.

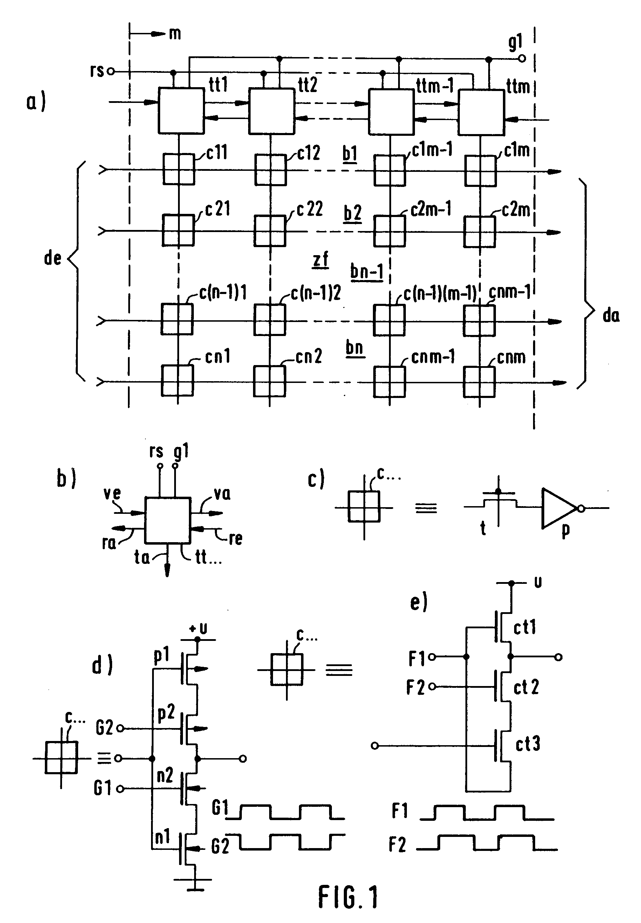

Im stark schematisierten Schaltbild der Fig. 1a sind von n möglichen die parallelen Signalzweige b1, b2, bn-1, bn, gezeigt. Im Signalzweig b1 sind die erste Speicherzelle c11, die zweite Speicherzelle c12, die vorletzte Speicherzelle c1m-1 die letzte Speicherzelle c1m vorhanden. Im zweiten Signalzweig b2 tragen die entsprechenden Speicherzellen die Bezugszeichen c21, c22, c2m-1, c2m, im vorletzten Signalzweig bn-1 die Bezugszeichen c(n-1)1, c(n-1)2, c(n-1) (m-1), c(n-1)m und im letzten Signalzweig bn die Bezugszeichen cn1, cn2, cnm-1, cnm. Alle diese Speicherzellen bilden das Zellenfeld zf.

Jeder der m Zellen gleicher Ordnung in den Signalzweigen ist ein Takttreiber tt... zugeordnet, dessen Taktausgang ta mit den Enable-Eingängen der jeweiligen Speicherzellen verbunden ist. Somit ist allen ersten Speicherzellen c..1 der Takttreiber tt1, allen zweiten Speicherzellen c..2 der Takttreiber tt2, allen vorletzten Speicherzellen c..(m-1) der Takttreiber ttm-1 und allen letzten Speicherzellen c..m der Takttreiber ttm zugeordnet.

Jeder Taktttreiber tt... hat entsprechend Fig. 1b die Datenverfügbarkeitseingangsleitung ve, die Datenverfügbarkeitsausgangsleitung va, die Datenanforderungseingangsleitung re und die Datenanforderungsausgangsleitung ra. Die Datenverfügbarkeitseingangsleitung ve eines Takttreibers, z.B. des Takttreibers tt2, ist mit der Datenverfügbarkeitseingangsleitung va des direkt vorausgehenden Takttreibers, also des Takttreibers tt1, verbunden. Ferner ist die Datenanforderungseingangsleitung re eines Takttreibers z.B. des Takttreibers tt1, mit der Datenanforderungsausgangsleitung ra des nachfolgenden Takttreibers, also des Takttreibers tt2, verbunden. Dem jeweiligen Takteingang der Takttreiber tt.. ist das Grundtaktsignal g1 zugeführt, und sie geben das jeweilige Ausgangssignal ta ab.

Die Fig. 1c zeigt schematisch das Schaltbild einer ersten Variante der Speicherzellen. Dabei folgt dem Transfertransistor t der Pegelregenerierer p. Diese sind in der Zeichnung aus Vereinfachungsgründen zu einem kleinen Quadrat zusammengefaßt.

Die Fig. 1d zeigt das Schaltbild einer zweiten Variante der Speicherzellen, nämlich eine CMOS-Speicherzelle. Sie besteht aus der zwischen der positiven Betriebsspannung +u und deren negativen Bezugspunkt -u in der folgenden Reihenfolge liegenden Serienschaltung der gesteuerten Strompfade des ersten und des zweiten P-Transistors p1, p2 sowie des zweiten und des ersten N-Transistors n2, n1, wobei die Gates des ersten P- und des ersten N-Transistors miteinander verbunden den Eingang der Speicherzelle bilden, dem Gate des zweiten N-Transistors n2 das aus dem Ausgangssignal ta des Takttreibers tt.. abgeleitete Taktsignal G1 und dem Gate des zweiten P-Transistors p2 das dazu inverse Taktsignal G2 zugeführt ist. Der Verbindungspunkt der beiden zweiten Transistoren p2, n2 ist der Ausgang der Speicherzelle.

Die Fig. 1e zeigt das Schaltbild einer dritten Variante der Speicherzellen mit Transistoren eines einzigen Leitungstyps, z.B. vorzugsweise mit N-Transistoren. Sie besteht aus der am spannungsführenden Pol +u der Betriebsspannungsquelle beginnenden Reihenschaltung der gesteuerten Strompfade des ersten, des zweiten und des dritten Speicherzellentransistors ct1, ct2, ct3, von welch letzterem das Gate der Eingang der Speicherzelle ist. Der Verbindungspunkt des ersten und zweiten Speicherzellentransistors ct, ct2 bildet den Ausgang der Speicherzelle. Dem Gate des ersten Zellentransistors ct1 und dem nicht am Pol +u liegenden Ende der Reihenschaltung ist das erste vom Takttrieber abgegebene Taktsignal F1 und dem Gate des zweiten Zellentransistors ct2 das dagegen verzögerte und teilweise damit überlappende zweite vom Takttreiber abgegebene Taktsignal F2 zugeführt.

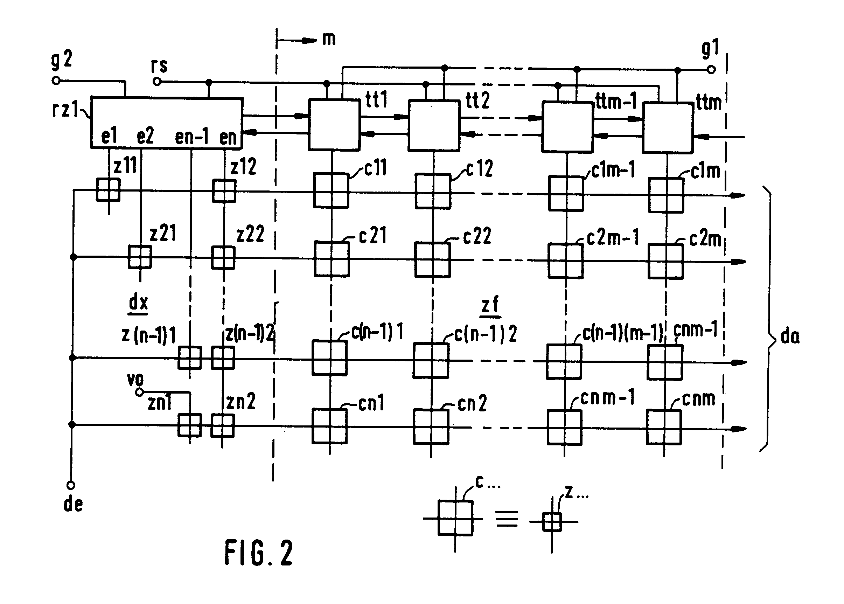

Die Fig. 2 zeigt das Zellenfeld nach Fig. 1 zusammen mit dem zwischen ihm und dem Dateneinganng de liegenden Demultiplexer dx. Dieser weist in jedem Signalzweig b... eine Demultiplexzelle auf, die in Signalflußrichtung aus der Serienschaltung der ersten und der zweiten Zusatzspeicherzelle z..1, z..2 besteht, die von gleicher Innenschaltung wie die Speicherzellen des Zellenfeldes sind. Beide Zellen sind entweder nach Fig. 1c oder 1d aufgebaut. Im ersten Signalzweig b1 liegen die Zusatzspeicherzellen z11, z12 in Serie, im zweiten Signalzeig b2 die Zusatzspeicherzellen z21, z22, im vorletzten Signalzweig bn-1 die Zusatzspeicherzellen z(n-1)1, z(n-1)2 und im letzten Signalzweig bn die Zusatzspeicherzellen zn1, zn2, wobei hier der Enable-Eingang der ersteren auf dem Potential vo liegt, das deren Eingang dauernd geöffnet hält, so daß Daten in diese Zelle dauernd gelangen können. Die Eingänge der ersten Zusatzspeicherzellen z..1 liegen am Dateneingang de des FIFO-Speichers.

Die Enable-Eingänge der Demultiplexzellen sind von n auf der Eingangsdatenrate g2 basierenden Eingangstaktsignalen e1, e2, en-1, en wie folgt angesteuert. Im ersten Signalzweig b1 ist die erste Zusatzspeicherzelle z11 vom ersten Eingang e1, im zweiten Signalzweig b2 die erste Zusatzspeicherzelle z21 vom zweiten Eingangstaktsignal e2, im vorletzten Signalzweig bn-1 die erste Zusatzspeicherzelle z(n-1)1 vom vorletzten Eingangstaktsignal en-1 angesteuert, während alle zweiten Zusatzspeicherzellen z..2 vom letzten Eingangstaktsignal en angesteuert sind. Als Eingangsdatenrate g2 wird dasjenige Taktsignal bezeichnet, mit dem getaktet die Eingangsdaten an den Dateneingang de gelangen.

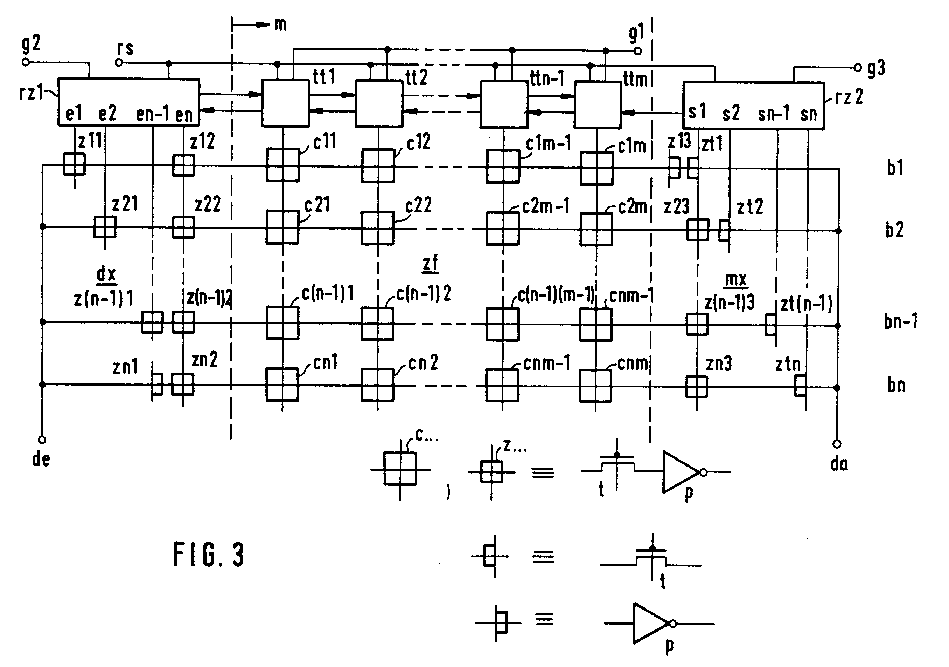

Fig. 3 zeigt eine Anordnung nach Fig. 2 für Speicherzellen nach Fig. 1c. Zwischen dem Datenausgang da und dem Zellenfeld zf liegt der Multiplexer mx. Dieser weist in jedem Signalzweig b... eine Mulitplexzelle auf, die jeweils in Signalflußrichtung aus der Serienschaltung der dritten Zusatzspeicherzelle z..3 und des Zusatz-Transfertransistors zt.. besteht, wobei allerdings in der Multiplexzelle des ersten Signalzweig b1 der Zusatz-Transfertransistor der dritten Zusatzspeicherzelle z13 entfällt. Im zweiten Signalzweig b2 besteht die Multiplexzelle somit aus der dritten Zusatzspeicherzelle z23 und dem Zusatztransfertransistor zt2, im vorletzten Signalzweig bn-1 aus der Zusatzspeicherzelle z(n-1)3 und dem Zusatztransfertransistor zt(n-1) und im letzten Signalzweig bn aus der Zusatzspeicherzelle zn3 und dem Zusatztransfertransistor ztn. Die Ausgänge der Zusatzspeicherzelle z13 und der Zusatztransfertransistoren zt2, zt(n-1), ztn führen zum Datenausgang da des FIFO-Speichers.

Die Gates der Transfertransistoren der Multiplexzellen von Fig. 3 sind von auf der Ausgangsdatenrate g3 basierenden Ausgangstaksignalen s1, s2, sn-1, sn wie folgt angesteuert: alle dritten Zusatzspeicherzellen z23, z(n-1)3, zn3 des zweiten bis letzten Signalzweigs sind ersten Ausgangstaktsignal s1 und der jeweilige Zusatztransfertransistor zt.. der Signalzweige b1...bn vom jeweils ersten bzw. zweiten bzw. letzten Ausgangstaktsignal s1..sn angesteuert. Mit Ausgangsdatenrate g3 ist dasjenige Taktsignal bezeichnet, mit dem getaktet die Ausgangsdaten vom Datenausgang da abgenommen werden.

Sowohl die Eingangstaktsignale e... als auch die Ausgangstaktsignale s... folgen mit ihren aktiven, d.h. die davon angesteuerten Transfertransistoren leitend steuernden, Impulsen zeitlich nichtüberlappend aufeinander. Die Frequenz der Eingangs- und die Ausgangsdatenrate g2, g3 ist jeweils kleiner/gleich dem halben n-fachen der Frequenz des Grundtaktsignals g1.

Die erste Zusatzspeicherzelle zn1 des letzten Signalzweigs ist in Fig. 3 lediglich als aus dem Pegelregenerierer p bestehend gezeigt, da der durch das Potential vo nach Fig. 2 dauernd leitend gesteuerte Transfertransistor t weggelassen werden kann.

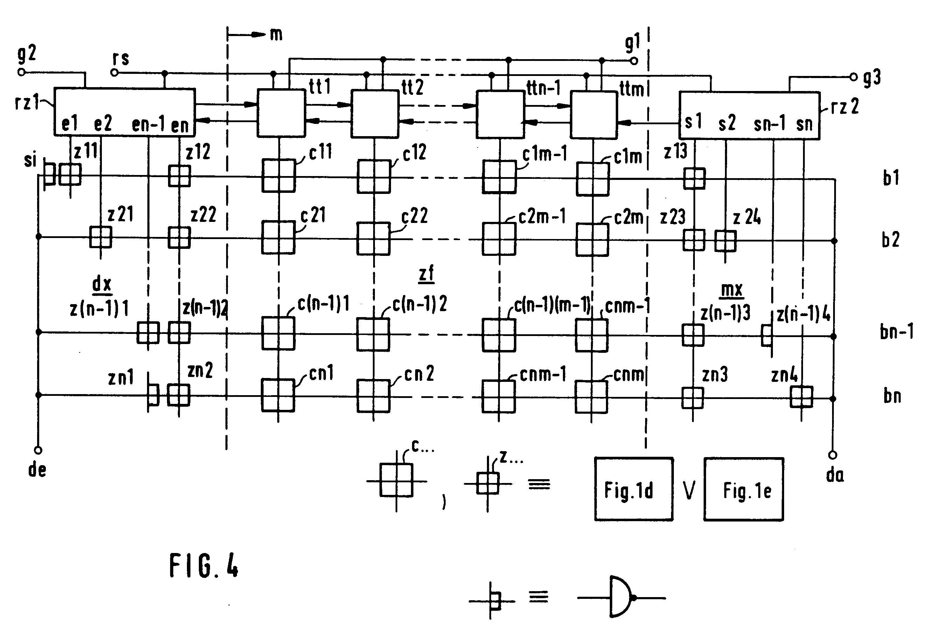

Fig. 4 zeigt eine Anordnung nach Fig. 2 für Speicherzellen nach Fig. 1d oder Fig. 1e. Zwischen dem Datenausgang da und dem Zellenfeld zf liegt der Multiplexer mx. Jede Multiplexzelle besteht in Signalflußrichtung aus der Serienschaltung der dritten und der vierten Zusatzspeicherzelle z..3, z..4 wobei die vierte Zusatzspeicherzelle des ersten Signalzeigs b1 entfällt. Die Enable-Eingänge dieser beiden Zusatzspeicherzellen sind von auf der Ausgangsdatenrate g3 basierenden Ausgangstaktsignalen s.. wie folgt angesteuert. Die dritten Zusatzspeicherzellen z..3 sind vom ersten Ausgangstaktsignal s1 und die jeweiligen vierten Zusatzspeicherzellen z..4 des zweiten bis letzten Signalzweigs b2...bn vom zweiten, vorletzten bzw. letzten Ausgangstaktsignal s2, sn-1, sn angesteuert.

Im ersten Signalzweig b1 ist der ersten Technologie (z.B. N-Kanal, CMOS) realisiert ist wie die Speicherzellen. Die Frequenz der Eingangs- und der Ausgangstaktsignale e.., s.. ist kleiner die halbe Frequenz es Grundtaksignals g1.

In bevorzugter Ausgestaltung der Erfindung werden die n Eingangstaktsignale e1...en und die n Ausgangstaktsignale s1...sn vom ersten n-stufigen Ringzähler rz1 bzw. zweiten-n-stufigen Ringzähler rz2 erzeugt. Beiden Ringzählern ist jeweils das Reset-Signal rs zugeführt. Die Eingangsdatenrate g2 ist dabei das Schiebesignal des ersten Ringzählers rz1, der im allgemeinen als ausgangs-eingangs-rückgekoppeltes Schieberegister realisiert sein wird. An den Stufenausgängen der n Stufen sind die Eingangstaktsignale e.. abzunehmen. Ferner ist der Ringzähler rz1 mit Datenanforderungsausgangsleitung ra des ersten Takttreibers tt1 verbunden, und der Ausgang der letzten Stufe ist mit der Datenverfügbarkeitseingangsleitung ve des ersten Takttreibers tt1 gekoppelt.

Die Ausgangsdatenrate g3 ist das Schiebesignal des zweiten Ringzählers rz2, an dessen Stufenausgängen die n Ausgangstaktsignale s.. abzunehmen sind. Der Ausgang der ersten Stufe des Ringzählers rz2 ist mit der Datenanforderungseingangsleitung re des letzten Takttreibers ttn gekoppelt.

Vorzugsweise sind das Grundtaksignal g1 und die Eingangs- und die Augangsdatenrate g2, g3 jeweils nichtüberlappende Zweiphasensignale f1, f1q; f2, f2q; f3, f3q, deren jeweils erstes f.. dem jeweils zweiten f. .q voreilt.

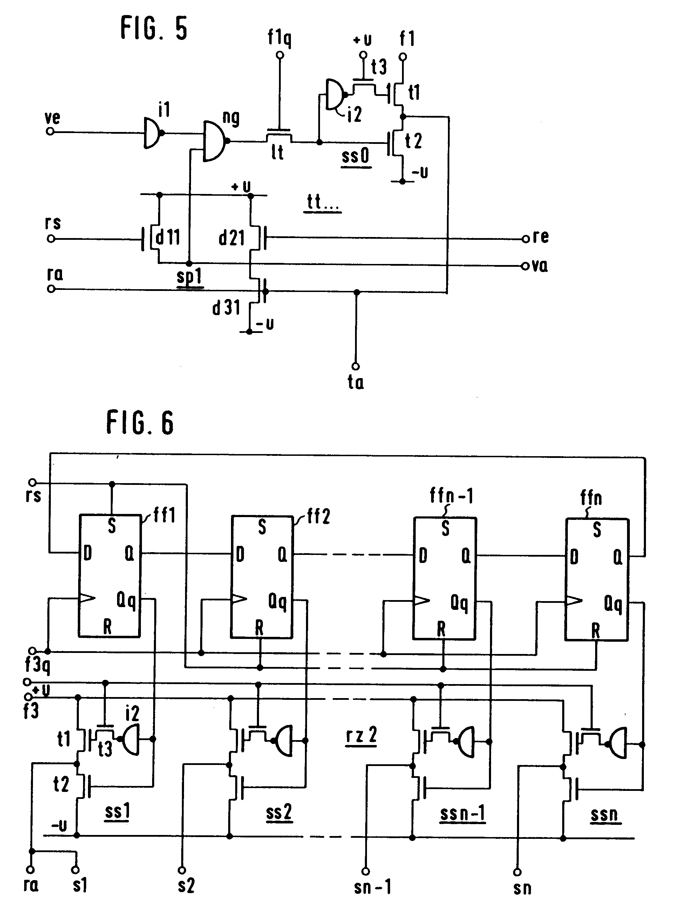

Die Fig. 5 zeigt das Schaltbild eines bevorzugten Ausführungsbeispiels eines Takttreibers tt.. in N-Kanal-Technik. Die Datenverfügbarkeitseingangsleitung ve liegt am Eingang des ersten Inverters i1, dessen Ausgang am ersten Eingang des NAND-Gatters ng angeschlossen ist. Die Datenverfügbarkeitsausgangsleitung va ist am Ausgang der ersten dynamischen Speicherstufe sp1 mit drei differenzverstärkerartig zwischen dem positiven und dem negativen Pol +u, -u der Betriebsgleichspannungsquelle liegenden Transistoren d11, d21, d31 angeschlossen, die im folgenden zur besseren Unterscheidbarkeit als Differenztransistoren bezeichnet werden. Dieser Ausgang ist der gemeinsame Verbindungspunkt der drei Differenztransistoren. Ferner liegt die Datenverfügbarkeitsausgangsleitung va am zweiten Eingang des NAND-Gatters ng.

Die Reset-Leitung rs liegt am Gate des ersten Differenztransistors d11 und die Datenanforderungseingangsleitung re am Gate des zweiten Differenztransistors d21. Die Datenanforderungsausgangsleitung ra ist am Ausgang der Taktschaltstufe ss0, am Gate des dritten Differenztransistors d31 und am Taktausgang ta angeschlossen.

Der Ausgang des NAND-Gatters ng liegt über den gesteuerten Strompfad des Längstranistors lt, dessen Gate des zweite Zweiphasensignal f1q des ersten Grundtaktsignals g1 zugeführt ist, am Eingang der Taktschaltstufe ss0. Diese ist wie folgt aufgebaut: der erste und der zweite Transistor t1, t2 liegen mit ihren gesteuerten Strompfaden in Serie zwischen dem ersten Zweiphasensignal f2 des Grundtaktsignals g1 und dem negativen Pol -u der Betriebsgleichspannungsquelle. Ferner liegen der zweite Inverter i2 und der dritte Transistor t3 in dieser Reihenfolge in Signalflußrichtung zwischen dem Eingang der Taktschaltstufe ss0 und dem Gate des ersten Transistors t1, wobei deren Eingang am Gate des zweiten Transistors t2 liegt un deren Ausgang der Verbindungspunkt der beiden Transistoren t1, t2 ist. Das Gate des dritten Transistors t3 liegt am positiven Pol +u der Betriebsspannungsquelle.

Die Fig. 6 zeigt das Schaltbild einer bevorzugten Ausführungsform in N-Kanal-Technik für den zweiten Ringzähler rz2. Jede seiner Stufen besteht aus dem D-Master-Slave-Flipflop ff1...ffn mit einem R-Eingang und einem S-Eingang am Slaveteil sowie der weiteren Taktschaltstufe ss1...ssn, an deren Eingang der Qq-Ausgang des D-Master-Slave-Flipflops ff.. liegt und die vom ersten Zweiphasensignal f3 der Ausgangsdatenrate g3 gespeist ist. Der Einfachheit halber sind die D-Master-Slave-Flipflops im folgenden als Flipflops bezeichnet.

Der Aufbau der weiteren Taktschaltstufen ss1, ss2, ssn-1, ssn ist identisch mit dem Aufbau der Taktschaltstufe ss0 nach Fig. 5, auf deren Erläuterung verwiesen wird.

Das Reset-Signal rs ist dem S-Eingang des ersten Flipflops ff1 und dem jeweiligen R-Eingang des zweiten bis n-ten Flipflops ff2...fn zugeführt. Das zweite Zweiphasensignal f3q der Ausgangsdatenrate g3 liegt am jeweiligen Takteingang der Flipflops ff.., und sie sind dadurch ringgeschaltet, daß jeweils der Q-Ausgang mit dem D-Eingang des nachfolgenden Flipflops verbunden ist, wobei der Q-Ausgang des letzten Flipflops ffn am D-Eingang des ersten Flipflops ff1 liegt. Am Ausgang der ersten weiteren Taktschaltstufe ss1 liegt die Datenanforderungsausgangsleitung ra des n-ten Takttreibers ttn.

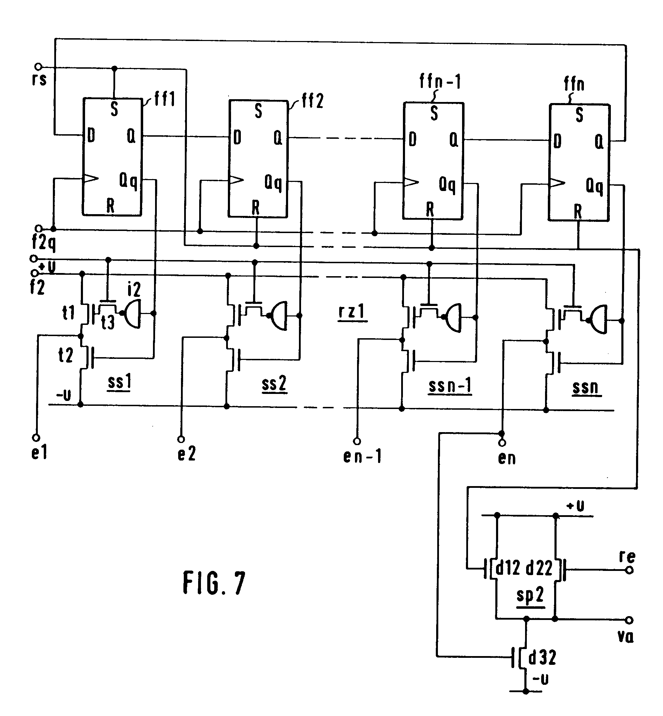

Die Fig. 7 zeigt ein bevorzugtes Ausführungsbeispiel in N-Kanal-Technik für den ersten Ringzähler rz1 nach Fig. 1. Er ist von seinem Aufbau her identisch mit dem zweiten Ringzähler rz2 nach Fig. 3, enthält jedoch zusätzlich zu deren Teilschaltungen noch die zweite dynamische Speicherstufe sp2 mit den drei differenzverstärkerartig untereinander verknüpften Differenztransistoren d12, d22, d32. In dieser zweiten Speicherstufe sp2 ist das Resetsignal rs dem Gate des ersten Differenztransistors d12 und das Ausgangssignal en der letzten Stufe, das auch das Ausgangssignal der letzten Taktschaltstufe ssn ist, dem Gate des dritten Differenztransistors d32 zugeführt. Am Gate des zweiten Differenztransistors d22 liegt die Datenanforderungseingangsleitung re des ersten Takttreibers tt1 und am Ausgang die Datenverfügbarkeitsausgangsleitung va dieses Takttreibers. Am Takteingang der Flipflopstufe ff1...ffn liegt das zweite Zweiphasensignal f2q der Eingangsdatenrate g2, während das zugehörige erste Zweiphasentaktsignal f2 den Taktschaltstufen ss1...ssn zugeführt ist.

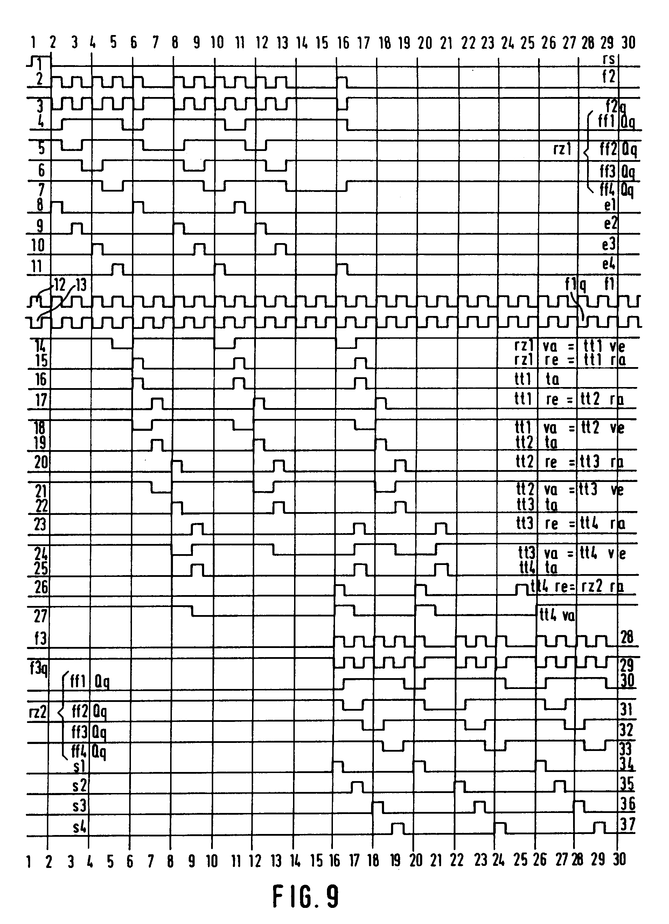

In Fig. 9 ist eine Schar von Signalverläufen gezeigt, die bei einer realisierten Ausführungsform der Erfindung entsprechend den Figuren 3 und 5 bis 7 dann auftreten, wenn m = n = 4 ist, d.h. also, wenn das Zellenfeld aus 4x4 Speicherzellen besteht. Zum Aufbau der Fig. 9 ist zunächst formal anzumerken, daß der zeitliche Ablauf während 30 Taktperioden der beiden Zweiphasensignale f1, f1q des Grundtaktsignals g1 gezeigt ist, wobei die einzelnen Taktperioden durch die in der obersten und der untersten Zeile der Fig. 9 angegebenen Zahlen 1 bis 30 fortlaufend numeriert sind.

Ferner sind in Fig. 9 die untereinander gezeichneten verschiedenen Signalverläufe mit den fortlaufend hintereinander geschriebenen Bezugszeichen aus den genannten Figuren versehen, so daß die Schaltungspunkte, an denen die einzelnen Signale auftreten, eindeutig identifiziert sind. So bezeichnet beispielsweise das zusammengesetzte Bezugszeichen rz1ff2Qq den Qq-Ausgang des Flipflops ff2 des Ringzählers rz1 nach Fig. 7. Aufgrund der konkreten 4x4-Zellenfeld-Anordnung treten anstatt der Laufzahlen n-1 bzw. n nach den Fig. 3, 6 und 7 die Laufzahlen 3 bzw. 4 in Fig. 9 auf, so daß beispielsweise das Bezugszeichen rz2ff3Qq den Qq-Ausgang des Flipflops ffn-1 des Ringzählers rz2 von Fig. 6 bedeutet.

Schließlich sind die einzelnen Kurven der Fig. 9 von oben nach unten fortlaufend mit den Zahlen 1 bis 37 numeriert. Dabei stehen die einzelnen Zahlen entweder unterhalb eines Signalpegels, wenn dieser den positiveren der beiden Binärpegel, also den H-Pegel, einnimmt, oder oberhalb eines Signalpegels, wenn dieser den L-Pegel am Ort der Zahl einnimmt. So steht die Zahl 1 unter dem H-Pegel des Signals rs, die Zahl 4 jedoch oberhalb des L-Pegels des Signals rz1ff1Qq. Die Zahlen 1 bis 27 stehen am linken Rand der Kurvenschar und die Zahlen 28 bis 27 an deren rechtem Rand. In der folgenden Beschreibung werden diese Zahlen als Numerierung der entsprechenden Kurve bzw. der entsprechenden Zeile von Fig. 9 benutzt, während die oben und unten in Fig. 9 eingetragene jeweils waagrechte Zahlenreihe zur Numerierung der Taktperioden bzw. Zeitpunkte herangezogen ist.

In Zeilen 12 und 13 sind die beiden Zweiphasensignale f1, f1q des Grundtaktsignals g1 als ununterbrochener Kurvenzug gezeigt, was angibt, daß es im Betrieb dauernd an den FIFO-Speicher der Erfindung angelegt ist. In Zeile 1 ist das Reset-Signal rs gezeigt, das während der Taktperiode Nr. 1 den H-Pegel aufweist und den FIFO-Speicher in seinen Null- bzw. Ausgangszustand versetzt. Die Kurven 2 und 3 zeigen die beiden zweiten Zweiphasensignale f2, f2q, die aus demjenigen Taktsignal abgeleitet sind, mit dem getaktet die Eingangsdaten an den Dateneingang de gelangen. Für die Fig. 9 ist vorausgesetzt, daß während der Taktperioden Nr. 7, 14, 15 und 17 bis 30 dem Dateneingang de keine Eingangsdaten zugeführt werden, so daß während dieser Taktperioden die beiden Zweiphasensignale jeweils den L-Pegel haben.

Lediglich für die Zwecke der besseren zeichnerischen Darstellung und damit der besseren Übersichtlichkeit der Fig. 9 haben darin die zweiten Zweiphasensignale f2, f2q und die ersten und die dritten Zweiphasensignale f1, f1q; f3, f3q beabsichtigterweise gleiche Periodendauern, wobei die Signallaufzeiten durch Gatter etc. nicht gezeichnet sind.

Die Kurve Nr. 4 zeigt, daß zu Beginn der zweiten Hälfte der Taktperiode Nr. 2 der Qq-Ausgang des Flipflops ff1 des ersten Ringzählers rz1 den H-Pegel annimmt. Dies ist darauf zurückzuführen, daß während der Dauer des H-Pegels des Reset-Signals rs nur der Q-Ausgang des Flipflops ff1 einen H-Pegel annimmt, während die Q-Ausgänge der restlichen Flipflops den L-Pegel haben, da das Reset-Signal an deren jeweiligem R-Eingang und somit auch am D-Eingang des Flipflops ff1 liegt. Dieser L-Pegel wird zum Q-Eingang durchgeschaltet, wenn das zweite Zweiphasensignal f2q einen H-Pegel annimmt, also zu Beginn der zweiten Hälfte der Taktperiode Nr. 2. Zu diesem Zeitpunkt wird aber auch der H-Pegel am D-Eingang des Flipflops ff2 an dessen Q-Ausgang durchgeschaltet, der während der Taktperiode Nr. 3 dort und am D-Eingang des Flipflops ff3 bleibt, so daß mit deren L/H-Flanke der H-Pegel an den Q-Ausgang des Flipflops ff3 gelangt. Mit der L/H-Flanke der Taktperiode Nr. 4 liegt somit am Q-Ausgang des Flipflops ff4 und auch am D-Eingang des Flipflops ff1 ein H-Pegel. An den Qq-Ausgängen der einzelnen Flipflops tritt dabei jeweils das zu den Signalen an den Q-Ausgängen inverse Signal auf. Dies zeigen die Kurven Nr. 5 bis 7, wobei sich die Pause in den Taktsignalen f2, f2q während der Taktperiode Nr. 7 in den Signalen der Kurven 4 bis 7 zeitlich entsprechend versetzt wiederfindet.

Die Kurven Nr. 8 bis 11 zeigen die Ausgangssignale der Taktschaltstufen ss1.. diese Ausgangssignale ergeben sich wie folgt, was anhand der Kurve Nr. 8 und der Taktschaltstufe ss1 erläutert wird. Während des H-Pegels des Zweiphasensignals f2 führt der Qq-Ausgang des Flipflops ff1 einen L-Pegel, der den Transistor t2 sperrt und andererseits über den Inverter i2 als H-Pegel an das Gate des Transistors t1 gelangt, so daß dieser leitend ist und sich somit der H-Pegel des Zweiphasensignals f2 zum Ausgang e1 überträgt. Tritt am Qq-Ausgang der H-Pegel auf, so wird der Transistor t2 leitend gesteuert und über den Inverter i2 der H-Pegel zum L-Pegel, so daß der Transistor t1 gesperrt wird und der Ausgang e1 praktisch auf das Potential -u gezogen wird, so daß an e1 wieder der L-Pegel auftritt.

Das eben erwähnte Auftreten des H-Pegels während der ersten Hälfte der Taktperiode Nr. 2 am Ausgang e1 tritt um jeweils eine Taktperiode versetzt ebenso an den Ausgängen e2, e3, e4 auf, d.h. also jeweils zu Beginn der Taktperioden Nr. 3 bis 5, wie dies in den Kurven Nr. 9 bis 11 gezeigt ist. Wenn zu Beginn der Taktperiode Nr. 5 am Ausgang e4 der H-Pegel auftritt, nimmt, wie die Kurve Nr. 14 zeigt, die Datenverfügbarkeitsausgangsleitung va des Ringzählers z1, die mit der Datenverfügbarkeitseingangsleitung ve des Takttreibers tt1 identisch ist, den L-Pegel an. Dies wird durch die dynamische Speicherzelle sp2 von Fig. 7 wie folgt bewirkt. Das Gate des Differenztransistors d12 ist mit dem Resetsignal rs gespeist und liegt somit auf dem L-Pegel, wodurch dieser Differenztransistor nichtleitend ist. Andererseits wird der Differenztransistor d32 durch den H-Pegel des Signals e4 leitend gesteuert, wodurch, da das Signal am Gate des Differenztransistors d22 ebenfalls L-Pegel hat (siehe Kurve Nr. 15) der gemeinsame Verbindungspunkt der drei Differenztransistoren auf den L-Pegel gelegt wird. Dieser bleibt während der Taktperiode Nr. 5 erhalten.

Die Kurve Nr. 15 zeigt das Datenforderungseingangssignal re des Ringzählers rz1, das mit dem Datenforderungsausgangssignal ra des Takttreibers tt1 identisch ist, da es von diesem stammt. In Fig. 5 liegt nämlich während der Taktperiode Nr. 5 der L-Pegel am Eingang des Inverters i1 und somit ein H-Pegel an dessen Ausgang. Da andererseits nach Kurve Nr. 18 die Datenverfügbarkeitsausgangsleitung va einen H-Pegel führt, leigt der Ausgang des NAND-Gatters ng auf dem L-Pegel. Dieser wird erst zum Eingang des Inverters i2 übertragen, wenn das zweite Zweiphasensignal f1q den H-Pegel annimmt, so daß der L-Pegel an dessen Ausgang den Transistor t1 noch gesperrt hält, der Transistor t2 durch den H-Pegel am Ausgang des NAND-Gatters ng jedoch leitend ist und somit das Signal am Ausgang ta einen L-Pegel hat.

Da schon in der zweiten Hälfte der Taktperiode Nr. 5 das erste Zweiphasensignal f1 auf den Ausgang ta durchgeschaltet wird, so daß ein L-Pegel dort liegt, nimmt der Ausgang ta zu Beginn der Taktperiode Nr. 6 den H-Pegel von f1 an. Dadurch geht der Pegel an va auf den L-Pegel und am Ausgang des NAND-Gatters tritt ein H-Pegel auf. Da dieser jedoch erst mit der zweiten Hälfte der Taktperiode Nr. 6 durch das zweite Zweiphasensignal f1q zum eingang des Inverters i2 durch geschaltet wird, bleibt während der ersten Hälfte der Taktperiode Nr. 6 in der Taktschaltstufe ss0 der Zustand der zweiten Hälfte der Taktperiode Nr. 5 erhalten. Wenn in deren zweiter Hälfte der Längstransistor lt leitend gesteuert wird, wird auch der Transistor t2 leitend, dagegen der Transistor t1 gesperrt gestuert, so daß am Ausgang ta wieder der L-Pegel auftritt. Dieser Ausgang führt also wie in Kurve 16 gezeigt, lediglich während der ersten Hälfte der Taktperiode Nr. 6 und dann auch wieder zu den entsprechenden Zeiten in den Taktperioden Nr. 11 und Nr. 17 den H-Pegel.

Ebenso wie der eben beschriebene Takttreiber tt1 arbeiten - nur zeitlich versetzt - die weiteren Takttreiber tt2, tt3, tt4, wie dies in den Kurven Nr. 19 bis 27 dargestellt ist. Auch in diesen Kurven findet sich die oben erwähnte Lücke in den Zweiphasensignalen f2, f2q während der Taktperiode Nr. 7 sich entsprechend zeitlich versetzt wieder.

Die Kurven Nr. 28 und 29 zeigen die beiden dritten Zweiphasensignale f3, f3q, mit denen getaktet die Ausgangsdaten vom Datenausgang da abgenommen werden. Während der Taktperioden Nr. 21 und 25 werden keine Ausgangsdaten abgenommen, so daß während dieser Taktperioden die beiden Zwiephasensignale f3, f3q jeweils den L-Pegel haben.

Die Kurven Nr. 30 bis 33 zeigen den Verlauf des Ausgangssignals an den Qq-Ausgängen der Flipflops ff1... ff4 des zweiten Ringzählers rz2 von Fig. 6, die ihrerseits die Taktschaltstufen ss1..ss4 ansteuern. An deren Ausgang treten dann die Ausgangstaktsignale s1..s4 nach den Kurven Nr. 34 bis 37 auf. Die Wirkungsweise der einzelnen Stufen der Fig. 6 ist mit der Wirkungsweise der entsprechenden Stufen der Fig. 7 identisch, so daß der Einfachheit halber darauf verwiesen wird.

## Patentansprüche

1. Digitaler FIFO-Speicher mit einem Speicherzellenfeld (zf) von n signalflußmäßig parallelen Signalzweigen (b1... bn), deren Eingänge mit dem Dateneingang (de) des Speichers und deren Ausgänge mit dessen Datenausgang (da) gekoppelt sind, wobei
- jeder Signalzweig m signalflußmäßig in Reihe liegende, untereinander gleichen Speicherzellen (c...) mit je einem Enable-Eingang enthält und
- diese mit Taktsignalen derart gespeist sind, daß in Signalflußrichtung benachbarte Speicherzellen nacheinander leitend gesteuert werden, und wobei folgende weitere Merkmale vorliegen:
- der Eingang des jeweiligen Signalzweigs ist direkt mit dem Dateneingang (de) verbunden und der Ausgang des jeweiligen Signalzweigs liegt direkt am Datenausgang (da),
- den n ersten bzw. den n zweiten bzw. den n m-ten Speicherzellen (c..1, c..2, c..m-1, c..m) ist jeweils ein erster bzw. ein zweiter bzw. ein m-ter Takttreiber (tt1, tt2, ttm-1, ttm) zugeordnet,
- den m gleichartig aufgebauten Takttreibern (tt..) ist ein Grundtaktsignal (g1) zugeführt, dessen Frequenz größer als das Doppelte der durch n geteilten maximalen Eingangsdatenrate (g2) ist,
- jeder Takttreiber weist eine erste Eingangsleitung (ve) (= Datenverfügbarkeitseingangsleitung) und eine erste Ausgangsleitung (va) (= Datenverfügbarkeitsausgangsleitung) auf, wobei die erste Eingangsleitung (ve) eines Takttreibers (tt2) mit der ersten Ausgangsleitung (va) des direkt vorausgehenden Takttreibers (tt1) verbunden ist, und weist eine zweite Eingangsleitung (re) (= Datenanforderungseingangsleitung) und eine zweite Ausgangsleitung (ra) (= Datenanforderungsausgangsleitung) auf, wobei die zweite Eingangsleitung (re) eines Takttreibers (tt1) mit der zweiten Ausgangsleitung (ra) des nachfolgenden Takttreibers (tt2) verbunden ist,
- der Datenverfügbarkeitseingangsleitung (ve) des ersten Takttreibers (tt1) ist ein Signal zugeführt, das das Anliegen gültiger Eingangsdaten anzeigt, und
- der Datenanforderungseingangsleitung (ra) des letzten Takttreibers (ttm) ist ein Signal zugeführt, das anzeigt, daß ein nächstes Datenwort zum Ausgang durchzuschalten ist,
gekennzeichnet durch folgende Merkmale:
- der digitale FIFO-Speicher enthält Isolierschicht-Feldeffekttransistoren,
- in jedem Signalzweig (b1..bn) ist der ersten Speicherzelle (c..1) die Demultiplexzelle eines Demultiplexers (dx) vor- und der letzten Speicherzelle (c.. m) die Multiplexzelle eines Multiplexers (mx) nachgeschaltet,
- jede Demultiplexzelle besteht in Signalflußrichtung aus der Serienschaltung einer ersten (z..1) und einer zweiten Zusatzspeicherzelle (z..2) von gleichartiger Innenschaltung wie die Speicherzellen, wobei in der Demultiplexzelle des letzten Signalzweigs (bn) der Enable-Eingang der ersten Zusatzspeicherzelle (zn1) auf einem Potential (vo) liegt, das deren Eingang dauernd geöffnet hält,
- die Enable-Eingänge der ersten Zusatzspeicherzellen sind von n auf der Eingangsdatenrate (g2) basierenden, nacheinander wirksam werdenden Eingangstaktsignalen (e . . ) derart angesteuert, daß im ersten bzw. zweiten bzw. (vorletzten) Signalzweig (b1, b2, bn-1) der ersten Zusatzspeicherzelle (z..1) das erste bzw. zweite bzw. vorletzte Eingangstaktsignal (e1, e2, en-1) und allen zweiten Zusatzspeicherzellen (z..2) das letzte Eingangstaktsignal (en) zugeführt sind, und
- die Frequenz des Eingangstaktsignals (e...) ist kleiner als die halbe Frequenz des Grundtaktsignals (g1).

2. Digitaler FIFO-Speicher nach Anspruch 1, dadurch gekennzeichnet, daß eine Speicherzelle, mit Transistoren eines einzigen Leitungstyps realisiert, in Signalflußrichtung aus einem Transfertransistor (t), dessen Gate der Enable-Eingang ist, und aus einem Pegelregenerierer (p), insbesondere einem statischen Inverter, besteht (Fig. 1c).

3. Digitaler FIFO-Speicher nach Anspruch 1, dadurch gekennzeichnet, daß eine Speicherzelle, in CMOS-Technik realisiert, aus der zwischen einer positiven Betriebsspannung (+u) und dem zugehörigen negativen Bezugspunkt (-u) in der folgenden Reihenfolge liegenden Serienschaltung der gesteuerten Strompfade eines ersten und eines zweiten P-Transistors (p1, p2) sowie eines zweiten und eines ersten N-Transistors (n2, n1) besteht, wobei die Gates des ersten P- und des ersten N-Transistors miteinander verbunden den Eingang der Speicherzelle bilden, dem Gate des zweiten N-Transistors (n2) ein aus dem Ausgangssignal (ta) des Takttreibers (tt..) abgeleitetes Taktsignal (G1) und dem Gate des zweiten P-Transistors (p2) das dazu inverse Taktsignal (G2) zugeführt ist sowie der Verbindungspunkt der beiden zweiten Transistoren (p2, n2) der Ausgang der Speicherzelle ist (Fig. 1d).

4. Digitaler FIFO-Speicher nach Anspruch 1, dadurch gekennzeichnet, daß eine Speicherzelle, mit Transistoren eines einzigen Leitungstyps realisiert, aus der am spannungsführenden Pol einer Betriebsspannungsquelle (u) beginnenden Reihenschaltung der gesteuerten Strompfade eines ersten, eines zweiten und eines dritten Speicherzellentransistors (ct1, ct2, ct3) besteht, von welch letzterem das Gate der Eingang der Speicherzelle ist, wobei der Verbindungspunkt des ersten und zweiten Speicherzellentransistors (ct1, ct2) den Ausgang der Speicherzelle bildet sowie dem Gate des ersten Speicherzellentransistors (ct1) und dem nicht an der Betriebsspannungsquelle (u) liegenden Ende der Reihenschaltung ein erstes vom Takttreiber abgegebenes Taktsignal (F1) und dem Gate des zweiten Speicherzellentransistors (ct2) ein dagegen verzögertes und teilweise damit überlappendes zweites vom Takttreiber abgegebenes Taktsignal (F2) zugeführt ist (Fig. 1e).

5. Digitaler FIFO-Speicher nach den Ansprüchen 1 und 2, gekennzeichnet durch folgende Merkmale:
- jede Multiplexzelle besteht in Signalflußrichtung aus der Serienschaltung einer dritten Zusatzspeicherzelle (z..3) vom gleichen Aufbau wie die Speicherzellen (c...) und eines Zusatz-Transfertransistors (zt..), wobei in der dritten Zusatzspeicherzelle des ersten Signalzweiges (b1) der Transfertransistor entfällt,
- die Gates der Transfertransistoren der Multiplexzellen sind von auf der Ausgangsdatenrate (g3) basierenden Ausgangstaktsignalen (s..) derart angesteuert, daß die dritten Zusatzspeicherzellen (z..3) des zweiten bis letzten Signalzweigs (b2...bn) vom ersten Ausgangstaktsignal (s1) und der erste, zweite, vorletzte bzw. letzte Zusatz-Transfertransistor (zt..) vom ersten, zweiten, vorletzten bzw. letzten Ausgangstaktsignal (s1, s2, sn-1, sn) angesteuert ist, und
- die Frequenz der Ausgangstaktsignale (s1, s2,..) ist kleiner als die halbe Frequenz des Grundtaktsignals (g1) (Fig. 3).

6. Digitaler FIFO-Speicher nach den Ansprüchen 1 und 3 oder 1 und 4, gekennzeichnet durch folgende Merkmale:
- jede Multiplexzelle besteht in Signalflußrichtung aus der Serienschaltung einer dritten und einer vierten Zusatzspeicherzelle (z..3, z..4) vom gleichen Aufbau wie die Speicherzellen (c...), wobei die vierte Zusatzspeicherzelle des ersten Signalzweigs (b1) entfällt,
- die Enable-Eingänge dieser beiden Zusatzspeicherzellen sind von auf der Ausgangsdatenrate (g3) basierenden Ausgangstaktsignalen (s..) derart angesteuert, daß die dritten Zusatzspeicherzellen (z..3) vom ersten Ausgangstaktsignal (s1) und die jeweiligen vierten Zusatzspeicherzellen (z..4) des zweiten bis letzten Signalzweigs (b2...bn) vom zweiten, vorletzten bzw. letzten Ausgangstaktsignal (s2, sn-1, sn) angesteuert sind, und
- im ersten Signalzweig (b1) ist der ersten Zusatzspeicherzelle (z11) ein statischer Inverter (si) vorgeschaltet, der in derselben Technologie (z.B. N-Kanal, CMOS) realisiert ist wie die Speicherzellen, und
- die Frequenz der Ausgangstaktsignale (s1, s2,...) ist kleiner als die halbe Frequenz des Grundtaktsignals (g1) (Fig. 4).

7. Digitaler FIFO-Speicher nach Anspruch 5 oder 6, dadurch gekennzeichnet, daß das Grundtaktsignal (g1) das Schiebesignal eines ersten n-stufigen Ringzählers (rz1) ist,
- an dessen Stufenausgängen die n Eingangstaktsignale (e..) abzunehmen sind,
- dem das Reset-Signal (rs) zugeführt ist,
- der mit der Datenanforderungsausgangsleitung (ra) des ersten Takttreibers (tt1) verbunden ist und
- bei dem der Ausgang der letzten Stufe mit der Datenverfügbarkeitseingangsleitung (ve) des ersten Takttreibers (tt1) gekoppelt ist, und
- daß die Ausgangsdatenrate (g3) das Schiebesignal eines zweiten Ringzählers (rz2) ist,
- an dessen Stufenausgängen die n Ausgangstaktsignale (s..) abzunehmen sind,
- dem das Reset-Signal (rs) zugeführt ist und
- bei dem der Ausgang der ersten Stufe mit der Datenanforderungseingangsleitung (re) des letzten Takttreibers (ttn) gekoppelt ist.

8. Digitaler FIFO-Speicher nach den Ansprüchen 5 und 7, dadurch gekennzeichnet, daß das Grundtaktsignal (g1) und die Eingangs- und die Ausgangsdatenrate (g2, g3) nichtüberlappende Zweiphasensignale (f1, f1q; f2, f2q; f3, f3q) entsprechender Frequenz sind, deren jeweils erstes (f..) dem jeweils zweiten (f..q) voreilt.

9. Digitaler FIFO-Speicher nach den Ansprüchen 1, 2, 7 und 8, gekennzeichnet durch einen Takttreiber (tt..) in N-Kanal-Technik mit folgenden Merkmalen:
- die Datenverfügbarkeitseingangsleitung (ve) liegt am Eingang eines ersten Inverters (i1), dessen Ausgang am ersten Eingang eines NAND-Gatters (ng) angeschlossen ist,
- die Datenverfügbarkeitsausgangsleitung (va) ist am Ausgang einer ersten dynamischen Speicherstufe (sp1) mit drei differenzverstärkerartig zwischen dem positiven (+u) und dem negativen (-u) Pol einer Betriebsgleichspannungsquelle liegenden Transistoren (= Differenztransistoren) (d11, d21, d31) angeschlossen, welcher Ausgang der gemeinsame Verbindungspunkt der gesteuerten Strompfade der Differenztransistoren ist, sowie auch am zweiten Eingang des NAND-Gatters (ng),
- der Reset-Eingang (rs) liegt am Gate des ersten Differenztransistors (d11) und die Datenanforderungseingangsleitung (re) liegt am Gate des zweiten Differenztransistors (d21),
- die Datenanforderungsausgangsleitung (ra) ist am Ausgang einer Taktschaltstufe (ssO), am Gate des dritten Differenztransistors (d31) und am Taktausgang (ta) angeschlossen, und
- der Ausgang des NAND-Gatters (ng) liegt über den gesteuerten Strompfad eines Längstransistors (lt), dessen Gate das zweite Zweiphasensignal (f1q) des ersten Grundtaktsignals (g1) zugeführt ist, am Eingang der Taktschaltstufe (ss0) (Fig. 5).

10. Digitaler FIFO-Speicher nach den Ansprüchen 7 bis 9, gekennzeichnet durch eine Ringzählerschaltung in N-Kanal-Technik für den zweiten Ringzähler (rz2) mit folgenden Merkmalen:
- jede Stufe besteht aus einem D-Master-Slave-Flipflop (= Flipflop) (ff1..ffn) mit einem R-Eingang und einem S-Eingang am Slaveteil sowie einer weiteren Taktschaltstufe (ss1..ssn),
- an deren Eingang der Qq-Ausgang des Flipflops (ff...) liegt,
- die vom ersten Zweiphasensignal (f3) der Ausgangsdatenraten (g3) gespeist ist und
- deren Ausgang der Ausgang für das jeweilige Ausgangstaktsignal (s1...sn) ist,
- das Resetsignal (rs) ist dem S-Eingang des ersten Flipflops (ff1) und dem jeweiligen R-Eingang des zweiten bis n-ten Flipflops (ff2...ffn) zugeführt,
- das zweite Zweiphasensignal (f3q) der Ausgangsdatenrate (g3) liegt am jeweiligen Takteingang der Flipflops (ff..),
- die Flipflops (ff..) sind dadurch ringgeschaltet, daß jeweils der Q-Ausgang mit dem D-Eingang des nachfolgenden Flipflops verbunden ist, und
- am Ausgang der ersten weiteren Taktschaltstufe (ss1) liegt die Datenanforderungsausgangsleitung (ra) des n-ten Takttreibers (ttn) (Fig. 6).

11. Digitaler FIFO-Speicher nach den Ansprüchen 7 bis 9, gekennzeichnet durch eine Ringzählerschaltung in N-Kanal-Technik für den ersten Ringzähler (rz1) mit folgenden Merkmalen:
- jede Stufe besteht
- aus einem D-Master-Slave-Flipflop (= Flipflop) (ff..) mit einem R-Eingang und einem S-Eingang am Slaveteil,
- aus einer weiteren Taktschaltstufe (ss..), an deren erstem Eingang der Qq-Ausgang des Flipflops (ff..) und an deren zweitem Eingang das erste Zweiphasensignal (f2) der Eingangsdatenrate (g2) liegt, und
- aus einer zweiten dynamischen Speicherstufe (sp2) mit drei differenzverstärkerartig zwischen dem positiven und dem negativen Pol der Betriebsgleichspannungsquelle liegenden Transistoren (= Differenztransistoren) (d12, d22, d32),
- das Resetsignal (rs) ist dem S-Eingang des ersten Flipflops (ff1), dem jeweiligen R-Eingang des zweiten bis n-ten Flipflops (ff2...ffn) und dem Gate des ersten Differenztransistors (d12) zugeführt,
- das zweite Zweiphasensignal (f2q) der Eingangsdatenrate (g2) liegt am jeweiligen Takteingang der Flipflops (ff..),
- die Flipflops (ff..) sind dadurch ringgeschaltet, daß jeweils der Q-Ausgang mit dem D-Eingang des nachfolgenden Flipflops verbunden ist,
- mit dem Gate des zweiten Differenzverstärkertransistors (d22) ist die Datenanforderungseingangsleitung (re) des ersten Takttreibers (tt1) und der Verbindungspunkt der drei Differenztransistoren mit der Datenverfügbarkeitsausgangsleitung (va) des ersten Takttreibers (tt1) verbunden, und
- das Gate des dritten Differenztransistors (d32) liegt am Ausgang der letzten weiteren Taktschaltstufe (ssn) (Fig. 7).

12. Digitaler FIFO-Speicher nach einem der Ansprüche 9 bis 11, gekennzeichnet durch eine Taktschaltstufe (ss..) in N-Kanaltechnik mit folgenden Merkmalen:
- ein erster und ein zweiter Transistor (t1, t2) liegen mit ihren gesteuerten Strompfaden in Serie zwischen dem jeweils ersten Zweiphasensignal (f2, f3) und dem negativen Pol (u-),
- ein dritter Transistor (t3) und ein zweiter Inverter (i2) liegen zwischen dem Eingang der Taktschaltstufe (ss..) und dem Gate des ersten Transistors (t1),
- der Eingang der Taktschaltstufe liegt am Gate des zweiten Transistors (t2),
- das Gate des dritten Transistors (t3) liegt am positiven Pol (+u) der Betriebsspannungsquelle, und
- der Ausgang der Taktschaltstufe ist der Verbindungspunkt der beiden Transistoren (t1, t2).

13. Digitaler FIFO-Speicher nach den Ansprüchen 1, 4, 6, 7, gekennzeichnet durch einen CMOS-Takttreiber (tt..) für ein Speicherfeld in N-Kanaltechnik mit folgenden Merkmalen:
- am einen Eingang eines doppeltgetakteten NOR-Gatters (ng) liegt die Datenverfügbarkeitseingangsleitung (ve),
- der gesteuerte Strompfad eines ersten N-Transistors (nn1) liegt zwischen dem anderen Eingang des NOR-Gatters (nr) und dem negativen Bezugspunkt (-u) einer Betriebsspannungsquelle (+u), dessen Gate der Reseteingang (rs) ist,
- zwischen der Betriebsspannung (+u) und deren Bezugspunkt (-u) liegt die Reihenschaltung der gesteuerten Strompfade eines ersten P-Transistors (pp1) und eines zweiten N-Transistors (nn2), deren Verbindungspunkt am anderen Eingang des NOR-Gatters (nr) und über einen ersten statischen Inverter (ci1) an der Datenverfügbarkeitsausgangsleitung (va) liegt,
- zwischen der Betriebsspannung (+u) und deren Bezugspunkt (-u) liegt die Serienschaltung eines zweiten und eines dritten P-Transistors (pp2, pp3) und eines dritten N-Transistors (nn3), wobei das Gate des zweiten P-Transistors (pp2) am Ausgang des NOR-Gatters (nr) angeschlossen ist und der Verbindungspunkt der beiden dritten Transistoren über einen zweiten statischen Inverter (ci2) am Ausgang für das zweite Taktsignal (F2) liegt,
- der Ausgang des NOR-Gatters (nr) liegt am Takteingang eines einfachgetakteten Inverters (ei),
- sein Ausgang ist mit Gate des ersten P-Transistors (pp1) und über einen dritten statischen Inverter (ci3) mit dem Gate des dritten N-Transistors (nn3) und mit dem Ausgang für das erste Taktsignal (F1) verbunden,
- aus dem Grundtaktsignal (g1) ist ein erstes und ein zweites Paar von jeweils nichtüberlappenden CMOS-Taktsignalen (m1, m1q; m2, m2q) abgeleitet, von denen das Signal m1 dem Gate des einfachgetakteten Inverters (ei), das Signal m2 dem Gate des dritten P-Transistors (pp3) und das zweite Paar (m2, m2q) dem NOR-Gatter zugeführt ist (Fig. 8).

## Claims

1. A digital FIFO memory comprising a memory cell array (zf) of n parallel signal channels (b1...bn) having their inputs connected to the data input (de) of the memory and having their outputs coupled to the data output (da) of the memory, with
- each signal channel containing m cascaded, identical memory cells (c...) each having an enable input, and
- clock signals being applied to the memory cells in such a way that memory cells which are adjacent in the direction of signal flow are rendered conductive one after the other, and with the following further features being present:
- The input of the respective signal channel is connected directly to the data input (de), and the output is coupled directly to the data output (da);
- a first clock driver (tt1), a second clock driver (tt2), and an mth clock driver (ttm-1, ttm) are associated with the n first memory cells (c..1), the n second memory cells (c..2), and the n mth memory cells (c..m-1, c..m), respectively;
- the m clock drivers (tt..), which are identical in construction, are supplied with a basic clock signal (g1) whose frequency is greater than twice the maximum input data rate (g2) divided by n;
- each clock driver has a first input line (ve) ( = data availability input line) and a first output line (va) (= data availability output line), with the first input line (ve) of a clock driver (tt2) connected to the first output line (va) of the directly preceding clock driver (tt1), as well as a second input line (re) (= data request input line) and a second output line (ra) (= data request output line), with the second input line (re) of a clock driver (tt1) connected to the second output line (ra) of the following clock driver (tt2);
- the data availability input line (ve) of the first clock driver (tt1) is supplied with a signal which indicates the presence of valid input data, and
- the data request input line (re) of the last clock driver (ttm) is supplied with a signal which indicates that a next data word has to be transferred to the output,
characterized by the following features:
- The digital FIFO memory includes insulated-gate field-effect transistors;
- in each signal channel (b1..bn), the first memory cell (c..1) is preceded by the demultiplex cell of a demultiplexer (dx), and the last memory cell (c..m) is followed by the multiplex cell of a multiplexer (mx);
- each demultiplex cell is formed by a cascade of a first (z..1) and a second additional memory cell (z..2) having the same internal circuitry as the memory cells, with the enable input of the first additional memory cell (zn1) in the demultiplex cell of the last signal channel (bn) connected to a potential (vo) which keeps the input of the first additional memory cell (zn1) constantly open;
- the enable inputs of the first additional memory cells are controlled by n successively acting input clock signals (e..) based on the input data rate (g2), with the first, second, and next-to-last input clock signals (e1, e2, en-1) being applied to the first additional memory cells (z..1) in the first, second, and next-to-last signal channels (b1, b2, bn-1), respectively, and the last input clock signal (en) being applied to all second additional memory cells (z..2), and
- the frequency of the input clock signal (e...) is less than half the frequency of the basic clock signal (g1).

2. A digital FIFO memory as claimed in claim 1,
characterized in that a memory cell, implemented with transistors of a single conductivity type, consists of a transfer transistor (t) followed by a level regenerator (p), particularly a static inverter, the gate of the transfer transistor (t) being the enable input (Fig. 1c).

3. A digital FIFO memory as claimed
in claim 1, characterized in that the memory cell, implemented in CMOS technology, consists of a first P-channel transistor (p1), a second P-channel transistor (p2), a second N-channel transistor (n2), and a first N-channel transistor (n1) having their controlled current paths connected in series in this order between a positive supply voltage (+u) and the associated negative reference point (-u), with the gates of the first P-channel transistor and the first N-channel transistor connected together to form the input of the memory cell, that a clock signal (G1) derived from the output (ta) of the clock driver (tt..) is applied to the gate of the second N-channel transistor (n2), that the clock signal inverse thereto (G2) is applied to the gate of the second P-channel transistor (p2), and that the junction point of the two second transistors (p2, n2) is the output of the memory cell (Fig. 1d).

4. A digital FIFO memory as claimed
in claim 1, characterized in that a memory cell, implemented with transistors of a single conductivity type, is formed by the series combination of the controlled current paths of a first memory-cell transistor (ct1), a second memory-cell transistor (ct2), and a third memory-cell transistor (ct3), said series combination beginning at the live terminal of a supply-voltage source (u), the gate of the third memory-cell transistor (ct3) being the input of the memory cell, the junction point of the first and second memory-cell transistors (ct1, ct2) forming the output of the memory cell, a first clock signal (F1) from the clock driver being applied to the gate of the first memory-cell transistor (ct1) and to the end of the series combination which is not connected to the supply-voltage source (u), and a second clock signal (F2) from the clock driver being applied to the gate of the second memory-cell transistor (ct2), said second clock signal (F2) being delayed with respect to and overlapping the first clock signal (F1) (Fig. 1e).

5. A digital FIFO memory as claimed in claims 1 and 2,
characterized by the following features:
- Each multiplex cell is formed by a cascade of a third additional memory cell (z..3) and an additional transfer transistor (zt..), with the third additional memory cell (z..3) being of the same construction as the memory cells (c..), and the transfer transistor in the third additional memory cell of the first signal channel (b1) omitted;
- the gates of the transfer transistors of the multiplex cells are controlled by output clock signals (s..) based on the output data rate (g3), with the first output clock signal (s1) being applied to the third additional memory cells (z..3) of the second to last signal channels (b2...bn), and the first, second, next-to-last, and last output clock signals (s1, s2, sn-1, sn) being applied to the first, second, next-to-last, and last additional transfer transistors (zt..), respectively, and
- the frequency of the output clock signals (s1, s2, ..) is less than half the frequency of the basic clock signal (g1) (Fig. 3).

6. A digital FIFO memory as claimed in claims 1 and 3 or 1 and 4, characterized by the following features:
- Each multiplex cell is formed by a cascade of a third additional memory cell (z..3) and a fourth additional memory cell (z..4) of the same construction as the memory cells (c...), with the fourth additional memory cell of the first signal channel (b1) omitted;
- the enable inputs of these two additional memory cells are controlled by output clock signals (s..) based on the output data rate (g3), with the first output clock signal (s1) being applied to the third additional memory cells (z..3), and the second, next-to-last, and last output clock signals (s2, sn-1, sn) being applied to the fourth additional memory cells (z..4) of the second to last signal channels (b2...bn), respectively;
- in the first signal channel (b1), the first additional memory cell (z11) is preceded by a static inverter (si) implemented in the same technology (e.g., N-channel, CMOS) as the memory cells, and
- the frequency of the output clock signals (s1, s2, ...) is less than half the frequency of the basic clock signal (g1) (Fig. 4).

7. A digital FIFO memory as claimed in claim 5 or 6, characterized in
- that the basic clock signal (g1) is the shift signal for a first n-stage ring counter (rz1)
- whose stage outputs provide the n input clock signals (e..),
- to which the reset signal (rs) is applied,
- which is connected to the data request output line (ra) of the first clock driver (tt1), and
- in which the output of the last stage is coupled to the data availability input line (ve) of the first clock driver (tt1), and
- that the output data rate (g3) is the shift signal for a second ring counter (rz2)
- whose stage outputs provide the n output clock signals (s..),
- to which the reset signal (rs) is applied, and
- in which the output of the first stage is coupled to the data request input line (re) of the last clock driver (ttn).

8. A digital FIFO memory as claimed in claims 5 and 7, characterized in that the basic clock signal (g1), the input data rate (g2), and the output data rate (g3) are non-overlapping two-phase signals (f1, f1q; f2, f2q; f3, f3q) of corresponding frequency, the first (f..) of each of which leads the second (f..q).

9. A digital FIFO memory as claimed in claims 1, 2, 7, and 8, characterized by a clock driver (tt..) in N-channel technology with the following features:
- The data availability input line (ve) is connected to the input of a first inverter (i1) having its output coupled to the first input of a NAND gate (ng);
- the data availability output line (va) is connected to the output of a first dynamic memory stage (sp1) consisting of three transistors (= differential transistors) (d11, d21, d31) connected in the manner of a differential amplifier between the positive terminal (+u) and the negative terminal (-u) of a DC supply voltage source, which output is the junction point of the control current paths of the differential transistors, and to the second input of the NAND gate (ng),
- the reset input (rs) is connected to the gate of the first differential transistor (d11), and the data request input line (re) is connected to the gate of the second differential transistor (d21);
- the data request output line (ra) is connected to the output of a clock-switching stage (ss0), to the gate of the third differential transistor (d31), and to the clock output (ta), and
- the output of the NAND gate (ng) is connected via the control led current path of a series transistor (lt), whose gate is supplied with the second two-phase siqnal (f1q) of the first basic clock signal (g1), to the input of the clock-switching stage (ss0) (Fig. 5).

10. A digital FIFO memory as claimed in claims 7 to 9, characterized by a circuit in N-channel technology for the second ring counter (rz2) with the following features:
- Each stage consists of a master-slave D flip-flop (= flip-flop) (ff1..ffn) and an additional clock-switching stage (ss1..ssn), the slave portion of the flip-flop (ff1..ffn) having an R input and an S input;
- the Qq output of the flip-flop (ff...) is coupled to the input of the additional clock-switching stage (ss1...ssn);
- the first two-phase signal (f3) of the output data rate (g3) is applied to the additional clock-switching stage (ss1..ssn), and
- the output of the additional clock-switching stage (ss1..ssn) is the output for the respective output clock signal (s1...sn);
- the reset signal (rs) is applied to the S input of the first flip-flop (ff1) and to the R inputs of the second to nth flip-flops (ff2...ffn);
- the second two-phase signal (f3q) of the output data rate (g3) is applied to the clock inputs of the flip-flops (ff..);
- the flip-flops (ff..) are connected in a ring circuit by coupling the respective Q output to the D input of the following flip-flop, and
- the output of the first additional clock-switching stage (ss1) is connected to the data request output line (ra) of the nth clock driver (ttn) (Fig. 6).

11. A digital FIFO memory as claimed in claims 7 to 9, characterized by a circuit in N-channel technology for the first ring counter (rz1) with the following features:
- Each stage consists of
- a master-slave D flip-flop (= flip-flop) (ff..) having an R input and an S input at the slave portion,
- an additional clock-switching stage (ss..) having its first input connected to the Qq output of the flip-flop (ff..) and having the first two-phase signal (f2) of the input data rate (g2) applied to its second input, and
- a second dynamic memory stage (sp2) consisting of three transistors (= differential transistors) (d12, d22, d32) connected in the manner of a differential amplifier between the positive and negative terminals of the DC supply voltage source;
- the reset signal (rs) is applied to the S input of the first flip-flop (ff1), to the R input of the second to nth flip-flops (ff2...ffn), and to the gate of the first differential transistor (d12);
- the second two-phase signal (f2q) of the input data rate (g2) is applied to the clock inputs of the flip-flops (ff..);
- the flip-flops (ff..) are connected in a ring circuit by coupling the respective Q output to the D input of the following flip-flop;
- connected to the gate of the second differential transistor (d22) is the data request input line (re) of the first clock driver (tt1) and the junction point of the three differential transistors with the data availability output line (va) of the first clock driver (tt1), and
- the gate of the third differential transistor (d32) is connected to the output of the last additional clock-switching stage (ssn) (Fig. 7).

12. A digital FIFO memory as claimed in any one of claims 9 to 11, characterized by a clock-switching stage (ss..) in N-channel technology with the following features:
- A first transistor (t1) and a second transistor (t2) have their controlled current paths connected in series between the respective first two-phase signal (f2, f3) and the negative terminal (-u);
- a third transistor (t3) and a second inverter (i2) are connected between the input of the clock-switching stage (ss..) and the gate of the first transistor (t1);
- the input of the clock-switching stage is connected to the gate of the second transistor (t2);
- the gate of the third transistor (t3) is connected to the positive terminal (+u) of the supply voltage source, and
- the output of the clock-switching stage is the junction point of the two transistors (t1, t2).

13. A digital FIFO memory as claimed in claims 1, 4, 6, and 7, characterized by a CMOS clock driver (tt..) for a memory array in N-channel technology with the following features:
- The data availability input line (ve) is connected to one input of a NOR gate (nr) clocked by two clock signals;
- the controlled current path of a first N-channel transistor (nn1) is connected between the other input of the NOR gate (nr) and the negative reference point (-u) of a supply voltage source (+u), the gate of the first N-channel transistor (nn1) being the reset input (rs);
- connected between the supply voltage (+u) and its reference point (-u) is the series combination of the controlled current paths of a first P-channel transistor (pp1) and a second N-channel transistor (nn2), whose junction point is connected to the other input of the NOR gate (nr) and, through a first static inverter (ci1), to the data availability output line (va);
- connected between the supply voltage (+u) and its reference point (-u) is the series combination of a second P-channel transistor (pp2), a third P-channel transistor (pp3), and a third N-channel transistor (nn3), with the gate of the second P-channel transistor (pp2) connected to the output of the NOR gate (nr), and the junction point of the two third transistors connected through a second static inverter (ci2) to the output for the second clock signal (F2);
- the output of the NOR gate (nr) is connected to the clock input of an inverter (ei) clocked by a single clock signal;
- the output of this inverter (ei) is connected to the gate of the first P-channel transistor (pp1) and, through a third static inverter (ci3), to the gate of the third N-channel transistor (nn3) and to the output for the first clock signal (F1), and
- from the basic clock signal (g1), a first pair (m1, m1q) and a second pair (m2, m2q) of nonoverlapping CMOS clock signals are derived, the signal m1 of the first pair being applied to the gate of the inverter (ei) clocked by a single clock signal, the signal m2 of the second pair being applied to the gate of the third P-channel transistor (pp3), and the second pair (m2, m2q) being applied to the NOR gate (Fig. 8).

## Revendications

1. Mémoire FIFO numérique comportant un champ (zf) de cellules de mémoire comprenant n branches de transmission de signaux (b1... bn), parallèles dans le sens de transmission des signaux, dont les entrées sont raccordées à l'entrée de données (de) de la mémoire et dont les sorties sont couplées à la sortie de données (da) de la mémoire, et dans laquelle
- chaque branche de transmission de signaux contient m cellules de mémoire identiques (c...), qui sont branchées en série dans le sens de transmission des signaux et comportent chacune une entrée de validation,
- ces cellules sont alimentées par des signaux de cadence de sorte que des cellules de mémoire, qui sont voisines dans le sens de transmission des signaux, sont placées successivement à l'état conducteur, et dans laquelle il est prévu les caractéristiques supplémentaires suivantes :
- l'entrée de chaque branche de transmission de signaux est raccordée directement à l'entrée de données (de) et la sortie de chaque branche de transmission de signaux est raccordée directement à la sortie de données (de),
- respectivement un premier, un second et un m-ème étage d'attaque de cadence (tt1, tt2, ttm-1, ttm) sont associés aux n premières, aux n secondes ou aux n m-èmes cellules de mémoire (c...1, c...2, c...m-1, c...m),
- aux m étages d'attaque de cadence (tt...) possédant le même agencement est envoyé un signal de cadence de base (g1), dont la fréquence est supérieure au double de la cadence maximale (g2) des données d'entrée, divisée par n,
- chaque étage d'attaque de cadence possède une première ligne d'entrée (ve) (= ligne d'entrée de disponibilité de données) et une première ligne de sortie (va) (= ligne de sortie de disponibilité de données), la première ligne d'entrée (ve) d'un étage d'attaque de cadence (tt2) étant raccordée à la première ligne de sortie (va) de l'étage d'attaque de cadence directement précédent (tt1), et possède une seconde ligne d'entrée (re) (= ligne d'entrée de demandes de données) et une seconde ligne de sortie (ra) (= ligne de sortie de demandes de données), la seconde ligne d'entrée (re) d'un étage d'attaque de cadence (tt1) étant raccordée à la seconde ligne de sortie (ra) de l'étage d'attaque de cadence suivant (tt2),
- un signal, qui indique l'application de données d'entrée valables, est envoyé à la ligne d'entrée de disponibilité de données (ve) du premier étage d'attaque de cadence (tt1), et
- un signal, qui indique qu'un mot de données immédiatement suivant doit être transmis à la sortie, est envoyé à la ligne d'entrée de demande de données (ra) du dernier étage d'attaque de cadence (ttm),
caractérisée par les caractéristiques suivantes :
- la mémoire FIFO numérique contient des transistors à effet de champ à couche isolante,
- dans chaque branche de transmission de signaux (b1...bn), la cellule de démultiplexage d'un démultiplexeur (dx) est branchée en amont de la première cellule (c...1) et la cellule de multiplexage d'un multiplexeur (mx) est branchée en aval de la dernière cellule de mémoire (c...m),
- chaque cellule de démultiplexage est constituée, dans le sens de transmission des signaux, par le montage série d'une première cellule de mémoire supplémentaire (z...1) et d'une seconde cellule de mémoire supplémentaire (z...2) possédant un circuit interne identique à celui des cellules de mémoire, l'entrée de validation de la première cellule de mémoire supplémentaire (zn1) étant placée à un potentiel (vo), qui maintient en permanence ouverte l'entrée de cette cellule, dans la cellule de démultiplexage de la dernière branche de transmission de signaux (bn),
- les entrées de validation des premières cellules de mémoire supplémentaires sont commandées par n des signaux de cadence d'entrée (e...), qui sont basés sur la cadence de données d'entrée (g2) et sont activés d'une manière successive, de sorte que, dans la première, la seconde et l'avant-dernière branche de transmission de signaux (b1, b2, bn-1), le premier, le second et l'avant-dernier signal de cadence d'entrée (e1, e2, en-1) sont envoyés à la première cellule de mémoire supplémentaire (z...1) et le dernier signal de cadence d'entrée (en) est envoyé à toutes les secondes cellules de mémoire supplémentaires (z...2), et
- la fréquence du signal de cadence d'entrée (e...) est inférieure à la moitié de la fréquence du signal de cadence de base (g1).

2. Mémoire FIFO numérique selon la revendication 1, caractérisée en ce qu'une cellule de mémoire, réalisée avec des transistors possédant un type unique de conductivité, est constituée, dans le sens de transmission des signaux, par un transistor de transfert (t), dont la grille est l'entrée de validation, et par un régénérateur de niveau (p), notamment un inverseur statique (figure 1c).

3. Mémoire FIFO numérique selon la revendication 1, caractérisée en ce qu'une cellule de mémoire, réalisée suivant la technique CMOS, est constituée par le montage série, qui est situé entre une tension de service positive (+u) et le point de référence négatif associé (-u) dans la séquence suivante et est formé par les voies de courant commandées de premier et second transistors à canal P (p1, p2) ainsi que d'un second et d'un premier transistor à canal N (n2, n1), les grilles du premier transistor à canal P et du premier transistor à canal N étant raccordées entre elles en formant l'entrée de la cellule de mémoire, tandis qu'un signal de cadence (G1) tiré du signal de sortie (ta) de l'étage d'attaque de cadence (tt...) est appliqué à la grille du second transistor à canal N (n2) et que le signal de cadence (G2), inverse du précédent, est appliqué à la grille du second transistor à canal P (p2), et que le point de jonction des deux transistors (p2, n2) forme la sortie de la cellule de mémoire (figure 1d).

4. Mémoire FIFO numérique selon la revendication 1, caractérisée en ce qu'une cellule de mémoire, qui est réalisée avec des transistors possédant un type unique de conductivité, est constituée par le montage série, qui commence au niveau du pôle d'application de la tension d'une source de tension de service (u) et est formé par les voies de courant commandées d'un premier, d'un second et d'un troisième transistors (ct1, ct2, ct3) de la cellule de mémoire, dans laquelle la grille du dernier transistor constitue l'entrée de la cellule de mémoire, le point de jonction des premier et second transistors (ct1, ct2) de la cellule de mémoire forme la sortie de cette dernière, et un premier signal de cadence (F1) délivré par l'étage d'attaque de cadence est appliqué à la grille du premier transistor (ct1) de la cellule de mémoire et à l'extrémité du circuit série, qui n'est pas raccordée à la source de tension de service (u), et un second signal de cadence (F2) retardé par rapport au premier, partiellement en chevauchement avec ce signal et délivré par l'étage d'attaque de cadence est appliqué à la grille du second transistor (ct2) de la cellule de mémoire (figure 1e).

5. Mémoire FIFO numérique selon les revendications 1 et 2, caractérisée par les caractéristiques suivantes :
- chaque cellule de multiplexage est constituée, dans le sens de transmission des signaux, par le circuit série formé d'une troisième cellule de mémoire supplémentaire (z...3) possédant la même constitution que les cellules de mémoire (c...), et d'un transistor de transfert supplémentaire (zt...), le transistor de transfert n'existant pas dans la troisième cellule de mémoire supplémentaire de la première branche de transmission de signaux (b1),
- les grilles des transistors de transfert des cellules de multiplexage sont commandées par des signaux de cadence de sortie (s...), qui sont basées sur la cadence des données de sortie (g3), de telle sorte que les troisièmes cellules de mémoire suplémentaire (g...3) de la seconde jusqu'à la dernière branche de transmission de signaux (b2...bn) sont commandées par un premier signal de cadence de sortie (s) et que le premier, le second, l'avant-dernier et le dernier transistors de transfert supplémentaires (zt...) sont commandés par le premier, le second, l'avant-dernier et le dernier signal de cadence de sortie (s1, s2, sn-1, sn), et
- la fréquence des signaux de cadence de sortie (s1,s2,...) est inférieure à la moitié de la fréquence du signal de cadence de base (g1) (figure 3).

6. Mémoire FIFO numérique selon les revendications 1 et 3 ou 1 et 4, caractérisée par les caractéristiques suivantes :
- chaque cellule de multiplexage est constituée, dans le sens de transmission des signaux, par le circuit série formé d'une troisième et d'une quatrième cellules de mémoire supplémentaires (z...3, z...4) possédant la même constitution que les cellules de mémoire (c...), la quatrième cellule de mémoire supplémentaire de la première branche de transmission de signaux (b1) étant supprimée,
- les entrées de validation de ces deux cellules de mémoire supplémentaires sont commandées par les signaux de cadence de sortie (s...), qui sont basés sur la cadence de données de sortie (g3), de sorte que les troisièmes cellules de mémoire supplémentaires (z...3) sont commandées par le premier signal de cadence de sortie (s1) et que les quatrièmes cellules de mémoire supplémentaires respectives (z ... 4) de la seconde jusqu'à la dernière branche de transmission de signaux (b2 ... bn) sont commandées par le second, l'avant-dernier et le dernier signal de cadence de sortie (s2, sn-1, sn), et
- dans la première branche de transmission de signaux (b), en amont de la première cellule de mémoire supplémentaire (z) est branché un inverseur statique (si), qui est réalisé avec la même technologie (par exemple CMOS, canal N), que les cellules de mémoire, et
- la fréquence des signaux de cadence de sortie (s1, s2, ...) est inférieure à la moitié de la fréquence du signal de cadence de base (g1) (figure 4).

7. Mémoire FIFO numérique suivant la revendication 5 ou 6, caractérisée par le fait que le signal de cadence de base (g1) est le signal de transfert d'un premier compteur annulaire (rz1) à n étages,
- sur les sorties des étages duquel on peut prélever les n signaux de cadence d'entrée (e...),
- auquel est envoyé le signal de remise à l'état initial (rs),
- qui est raccordé à la ligne de sortie de demande de données (ra) du premier étage d'attaque de cadence (tt1), et
- dans lequel la sortie du dernier étage est couplée à la ligne d'entrée de disponibilité de données (ve) du premier étage d'attaque de cadence (tt1), et
- que la cadence de données de sortie (g3) représente le signal de transfert d'un second compteur annulaire (rz2),
- sur les sorties d'étages duquel on peut prélever les n signaux de cadence de sortie (s...),
- auquel est envoyé le signal de remise à l'état initial (rs), et
- dans lequel la sortie du premier étage est couplée à la ligne d'entrée de demande de données (re) du dernier étage d'attaque de cadence (ttn).

8. Mémoire FIFO numérique selon les revendications 5 et 7, caractérisée en ce que le signal de cadence de base (g1) et les cadences de données d'entrée et de sortie (g2, g3) sont des signaux biphasés non en chevauchement (f1, f1q; f2, f2q; f3, f3q) possédant une fréquence correspondante et dont respectivement le premier (f...) est en avance sur respectivement le second (f...q).

9. Mémoire FIFO numérique selon les revendications 1, 2, 7 et 8, caractérisée par un étage d'attaque de cadence (tt...) réalisé selon la technique à canal N, présentant les caractéristiques suivantes :
- la ligne d'entrée de disponibilité de données (ve) est raccordée à l'entrée d'un premier inverseur (i1), dont la sortie est raccordée à la première entrée d'une porte NON-ET (ng),
- la ligne de sortie de disponibilité de données (va) est raccordée à la sortie d'un premier étage de mémoire dynamique (sp1) comportant trois transistors (= transistors de formation de différence) (d11, d21, d31), raccordés entre le pôle positif (+u) et le pôle négatif (-u) d'une source de tension continue de service, ladite sortie constituant le point commun de raccordement des voies de courant commandées des transistors de formation de différence, ainsi qu'à la seconde entrée de la porte NON-ET (ng),
- l'entrée de remise à l'état initial (rs) est raccordée à la grille du premier transistor de formation de différence (d11) et la ligne d'entrée de demandes de données (re) est raccordée à la grille du second transistor de formation de différence (d21),
- la ligne de sortie de demande de données (ra) est raccordée à la sortie d'un étage de commutation de cadence (ss0), à la sortie du troisième transistor de formation de différence (d31) et à la sortie de cadence (ta), et
- la sortie de la porte NON-OU (ng) est raccordée à l'entrée de l'étage de commutation de cadence (ss0) par l'intermédiaire de la voie de courant commandée d'un transistor longitudinal (lt), à la grille duquel est envoyé le second signal biphasé (f1q) du premier signal de cadence de base (g1) (figure 5).

10. Mémoire FIFO numérique selon les revendications 7 à 9, caractérisée par un circuit de comptage en anneau réalisé selon la technique à canal N pour le second compteur en anneau (rz2), présentant les caractéristiques suivantes :
- chaque étage est constitué par une bascule bistable maître-esclave de type D (= flipflop) (ff1...ffn) comportant une entrée R et une entrée S dans la partie esclave, ainsi qu'un autre étage de commutation de cadence (ss1...ssn),
- à l'entrée duquel est raccordée la sortie Qq de la bascule bistable (ff...),
- qui est alimenté par le second signal biphasé (f3) possédant la cadence de données de sortie (g3), et
- dont la sortie constitue la sortie du signal de cadence de sortie respectif (s1...sn),
- le signal de remise à l'état initial (rs) est envoyé à l'entrée S de la première bascule bistable (ff1) et à l'entrée R respective de la seconde jusqu'à la n-ème bascule bistable (ff2...ffn),
- le second signal biphasé (f3q) possédant la cadence de données de sortie (g3) est raccordé à l'entrée de cadence respective de la bascule bistable (ff...),
- les bascules bistables (ff...) sont raccordées en anneau de telle sorte que respectivement la sortie Q est raccordée à l'entrée D de la bascule bistable suivante, et
- à la sortie du premier étage suivant de commutation de cadence (ss1) est raccordée la ligne de sortie de demande de données (ra) du n-ème étage d'attaque de cadence (ttn) (figure 6).

11. Mémoire FIFO numérique selon les revendications 7 à 9, caractérisée par un circuit de comptage en anneau réalisé selon la technique à canal N pour le premier compteur en anneau (rz1), présentant les caractéristiques suivantes :
- chaque étage est constitué :
- par une bascule bistable maître-esclave de type D (= flipflop) (ff...) comportant une entrée R et une entrée S dans la partie esclave,
- par un autre circuit de commutation de cadence (ss...) à la première entrée duquel est raccordée la sortie Qq de la bascule bistable (ff...) et à la seconde entrée duquel est appliqué le premier signal biphasé (f2) possédant la cadence de données d'entrée (g2), et
- par un second étage de mémoire dynamique (sp2) comportant trois transistors (= transistors de formation de différence) (d12, d22, d32), branchés entre le pôle positif et le pôle négatif de la source de tension continue de service à la manière d'un amplificateur différentiel,
- le signal de remise à l'état initial (rs) est envoyé à l'entrée S de la première bascule bistable (ff1), à l'entrée R respective de la seconde jusqu'à la n-ème bascule bistable (ff2...ffn) et à la grille du premier transistor de formation de différence (d12),
- le second signal biphasé (f2q) possédant la cadence de données d'entrée (g2) est raccordé à l'entrée de cadence respective des bascules bistables (ff...),
- les bascules bistables (ff...) sont raccordées en anneau de sorte que respectivement la sortie (Q) est raccordée à l'entrée D de la bascule bistable suivante,
- la ligne d'entrée de demande de données (re) du premier étage de cadence (tt1) est raccordée à la grille du second transistor (d22) de l'amplificateur différentiel, et le point de jonction des trois transistors de formation de différence est raccordé à la ligne de sortie de disponibilité de données (va) du premier étage d'attaque de cadence (tt1), et
- la grille du troisième transistor de formation de différence (d32) est raccordée à la sortie de l'autre dernier étage de commutation de cadence (ssn) (figure 7).

12. Mémoire FIFO numérique selon l'une des revendications 9 à 11, caractérisée par un étage de commutation de cadence (ss...) réalisé selon la technique à canal N, présentant les caractéristiques suivantes :
- des premier et second transistors (t1, t2) sont raccordés, par leurs voies de courant commandées, en série entre le premier signal biphasé respectif (f2, f3) et le pôle négatif (u-),
- un troisième transistor (t3) et un second inverseur (i2) sont branchés entre l'entrée de l'étage de commutation de cadence (ss...) et la grille du premier transistor (t),
- l'entrée de l'étage de commutation de cadence est raccordée à la grille du second transistor (t2),
- la grille du troisième transistor (t3) est raccordée au pôle positif (+u) de la source de tension de service, et
- la sortie de l'étage de commutation de cadence est formée par le point de jonction des deux transistors (t1, t2).

13. Mémoire FIFO numérique selon les revendications 1, 4, 6, 7, caractérisée par un étage d'attaque de cadence CMOS (tt...) pour une zone de mémoire, réalisé selon la technique à canal N, et présentant les caractéristiques suivantes :
- la ligne d'entrée de disponibilité de données (ve) est raccordée à une entrée d'une porte NON-OU (ng) commandée d'une manière doublement cadencée,
- la voie de courant commandée d'un premier transistor à canal N (nn1) est située entre l'autre entrée de la porte NON-OU (nr) et le point de référence négatif (-u) d'une source de tension de service (+u) et la grille de ce transistor constitue l'entrée de remise à l'état initial (rs),
- entre la tension de service (+u) et son point de référence (-u) est disposé le montage série formé des voies de courant commandées d'un premier transistor de type à canal P (pp1) et d'un second transistor à canal N (nn2), dont le point de jonction est raccordé à l'autre entrée de la porte NON-OU (nr) et, par l'intermédiaire d'un premier inverseur statique (ci1), à la ligne de sortie de disponibilité de données (va),
- entre la tension de service (+u) et son point de référence (-u) est situé le montage série d'un second et d'un troisième transistor à canal P (pp2, pp3) et d'un troisième transistor à canal N (nn3), la grille du second transistor à canal P (pp2) étant raccordée à la sortie de la porte NON-OU (nr) et le point de jonction des deux troisièmes transistors étant raccordé à la sortie pour le second signal de cadence (F2), par l'intermédiaire d'un second inverseur statique (ci2),
- la sortie de la porte NON-OU (nr) est raccordée à l'entrée de cadence d'un inverseur (ei) commandé par une seule cadence,
- sa sortie est raccordée à la grille du premier transistor à canal P (pp1) et, par l'intermédiaire d'un troisième inverseur statique (ci3), à la grille du troisième transistor à canal N (nn3) et à la sortie pour le premier signal de cadence (F1),
- à partir du signal de cadence de base (g1) sont formés des premier et second couples de signaux de cadence CMOS (m1, m1q; m2, m2q), qui ne sont respectivement pas en chevauchement, et parmi lesquels le signal m1 est envoyé à la grille de l'inverseur (ei) commandé par une seule cadence, le signal m2 est envoyé à la grille du troisième transistor à canal P (pp3), et le second couple (m2, m2q) est envoyé à la porte NON-OU (figure 8).
